# EUROPEAN PATENT SPECIFICATION

(11) **EP 1 675 445 B1**
(45) Date of publication and mention of the grant of the patent: **14.11.2007**
(21) Application number: 05027678.1
(22) Date of filing: 16.12.2005
(51) Int. Cl.: H05K 3/40

(54) **Method for producing semiconductor substrate**
Verfahren zur Herstellung eines Halbleitersubstrats
Procédé de fabrication d'un substrat semi-conducteur

(30) Priority: 24.12.2004 JP 2004373282
(43) Date of publication of application: 28.06.2006
(73) Proprietor: SHINKO ELECTRIC INDUSTRIES CO., LTD., Nagano-shi, Nagano 381-2287 (JP)
(72) Inventor: Kei, Murayama, 80, Oshimada-machi Nagano-shi Nagano 381-2287 (JP); Mitsutoshi, Higashi, 80, Oshimada-machi Nagano-shi Nagano 381-2287 (JP)
(74) Representative: Schmidt, Steffen J.

(56) References cited:
- US-A- 3 318 993
- US-A- 6 098 283
- US-A1- 2003 134 509
- US-A1- 2004 111 882
- US-B1- 6 426 241
- PATENT ABSTRACTS OF JAPAN vol. 015, no. 114 (E-1047), 19 March 1991 (1991-03-19) & JP 03 006829 A (FURUKAWA ELECTRIC CO LTD:THE), 14 January 1991 (1991-01-14)

## Description

### BACKGROUND OF THE INVENTION

### 1. Field of the Invention

The present invention relates to a method for producing a circuit board on which is mounted a semiconductor element and, particularly, to a method for producing a circuit board improved in the filling of an electro-conductive material in holes provided in substrate material.

### 2. Description of Related Invention

There is a circuit board on which are mounted semiconductor elements, wherein circuit patterns formed on both surfaces of a substrate having the electro-insulation are electrically connected to each other via conductive vias in through-holes provided through the substrate. Such a circuit board may be formed as a multi-layer circuit board by superposing a plurality of circuit patterns on both surfaces thereof via insulation layers, and a semiconductor device is produced by mounting semiconductor elements on the multi-layer circuit board. US3,318,993 describes a method for producing a pack of memory cards made of paper, plastic or other, preferably flexible, insulating substrate. Firstly, through the cards holes are punched. Then, a block of solder is placed over a top blank card of the pack of cards having aligning holes (column holes). Thereafter, the bundle of cards plus the solder will be placed in an oven, causing a melting of the solder. The melted solder flows into the holes by gravity and/or by applying pressure to the solder. US2004/0111882A1 describes a method for producing a printed wiring board-forming sheet. A conductive metal sheet made of solder is superposed on a resin sheet. A chip from the conductive metal sheet is formed by punching the conductive metal sheet. Consequently, the chip, moved by the punching, simultaneously punches a via hole into the resin sheet. Thereby, the via hole becomes filled with the chip punched out of the conductive metal sheet. US2003/0134509A1 describes a method for producing a conducting semiconductor wafer. At first, a wafer will be perforated with through-holes. Then, the perforated wafer will be arranged on molten solder. The molten solder is filled in the through-holes by firstly reducing a pressure in the area including the wafer and the molten solder and secondly returning the pressure to an ambient pressure.

Figs. 1 (a) to (f) illustrate a prior art disclosed in Patent document 1, wherein conductive metal is filled in the through-holes provided in an insulation and adhesive substrate by an electrolytic plating, and circuit patterns formed on one surface thereof via the conductive metal are electrically connected to those formed on the other surface in the same manner.

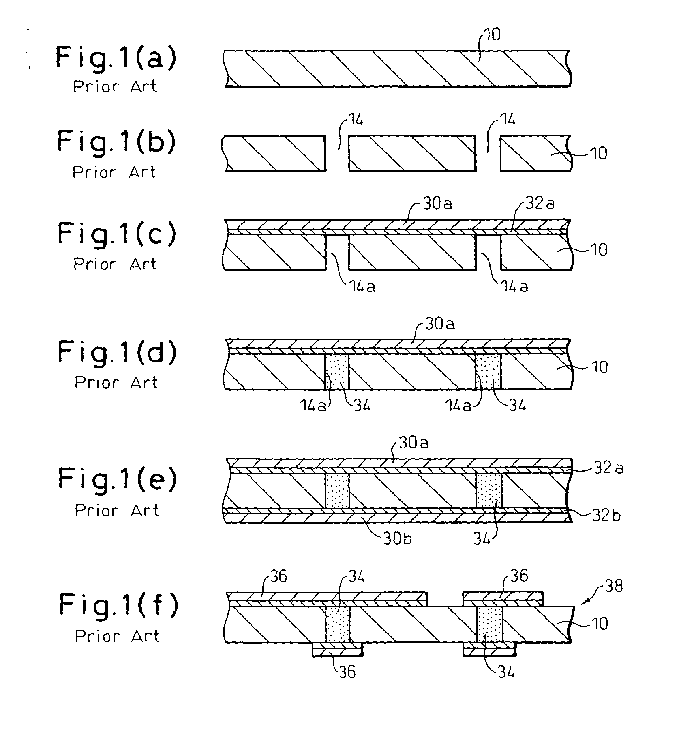

Fig. 1(a) illustrates a substrate 10 to be a body of the circuit board. The substrate 10 is an insulation material onto which a metallic foil such as copper foil forming a conductive layer for the circuit pattern is bonded by heating and pressing. For example, a non-cured resinous plate of a glass cloth impregnated with thermosettable resin can be used for the substrate 10.

Fig. 1(b) illustrates a state wherein through-holes 14 are provided in the substrate 10 by a laser beam machining. The through-holes 14 can be easily formed by the laser beam machining in the substrate 10 formed of the glass cloth impregnated with resin. According to the laser beam machining, even a through-hole 14 as small as less than 100µm diameter, which is difficult to mechanically drill, can be simply and accurately formed.

Fig. 1(c) shows a state wherein a copper foil 30a is bonded by the heating and pressing as a metallic foil onto one surface of the substrate 10 provided with the through-holes 14. The substrate 10 is formed of a glass cloth impregnated with non-cured thermosettable resin, and the resin is melted when the copper foil 30a is heated and pressed, and bonded to the substrate 10 as a one-piece body. In this regard, a barrier layer 32a of nickel is preliminarily provided on one surface of the copper foil 30a to be bonded to the substrate 10, and the copper foil 30a is bonded to the substrate 10 while using the barrier layer 32a as a surface to be bonded to the substrate 10. The barrier layer 32a prevents solder from being diffused into the copper foil 30a, to generate voids on the boundary surface, thus increasing the conductive resistance when the circuit patterns are electrically connected between the layers in a post process.

As shown in Fig. 1(c), as the copper foil 30a is bonded onto the one surface of the substrate 10, the through-hole 14 is closed on one side to define a recess 14a. Fig. 1(d) illustrates a state wherein the electrolytic plating has been carried out while using, as a power supply layer, the copper foil 30a bonded to the one surface of the substrate 10 to fill the interior of the recess 14a with conductive metal 34.

Fig. 1(e) illustrates a state wherein a copper foil 30b is bonded onto the other surface of the substrate 10 by the heating and pressing. On one surface of the copper foil 30b bonded to the other surface of the substrate 10, a barrier layer 32b of nickel is preliminarily provided in the same manner as described before. The conductive metal 34 is solder because solder melts due to the heating when the conductive metal 34 is heated and pressed onto the other surface of the substrate 10, as shown in Fig. 1(e), to weld the copper foil 30b with the conductive metal 34.

Regarding the copper foil 30a bonded to the one surface of the substrate 10, as the conductive metal 34 is bonded to the barrier layer 32a by the electrolytic plating, the conductive metal 34 is assuredly electrically conducted to the copper foil 30a. On the other hand, regarding the other surface of the substrate 10, the electric conduction between the conductive metal 34 and the copper foil 30b becomes insufficient if the copper foil 30b is merely bonded to the substrate 10. However, as the conductive metal 34 is melted when the copper foil 30b is thermally press-bonded to the substrate 10, the copper foil 30b is integral with the substrate 10, and the copper foil 30b is assuredly electrically connected with the conductive metal 34 during the thermal press-bonding of the copper foil 30b to the substrate 10. In this regard, while the resin in the substrate 10 is in a non-cured state upon bonding the copper foil 30b to the substrate 10, the resin is completely cured to bond the substrate 10 to the copper foil 30b as a one-piece body by heating the resin to a melting point and then cooling the same to a hardening point. Even if cracks are generated in the resin of the substrate in the preceding laser beam machining process, they are remedied by the process for integrally melt-bonding the copper foil 30b to the substrate 10.

Fig. 1(f) illustrates a state wherein circuit patterns 36 are formed on opposite surfaces of the substrate 10 by etching the copper foils 30a, 30b and the barrier layers 32a, 32b bonded thereto. The circuit patterns 36 formed on both surfaces of the substrate are electrically connected each other through the conductive metal 34 formed as conductive sections. Thus, the substrate shown in Fig. 1(f) forms a circuit board 38 in which the circuit patterns 36 formed on the both surfaces of the substrate are electrically conducted to each other via the conductive sections.

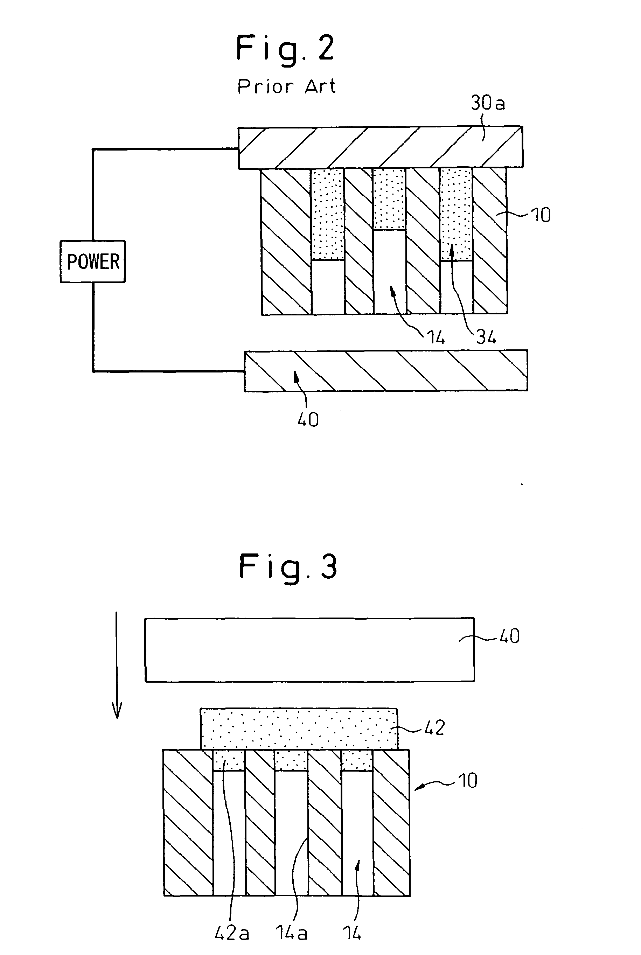

Fig. 2 illustrates in detail a process, disclosed in Patent Document 1, for filling the recesses 14a with the conductive metal 34 by plating as shown in Fig. 1(d). Note, in Fig. 2, the substrate 10 is a silicon substrate having a thickness in a range from 200 to 250µm and is provided with the through-holes 14 of 60 µm diameter at a pitch in a range from 100 to 200 µm.

In this case, the electrolytic plating is carried out while using, as a power supply layer, the copper foil 30a bonded to one surface of the substrate 10. An anode plate 40 of metal to be filled is disposed on a side of the other surface of the substrate 10 at a position slightly apart from the substrate 10, and the electrolytic plating is carried out in a proper electrolytic plating tank (not shown) by the well-known method. As the copper foil 30a is bonded to the one surface of the substrate 10, one of opposite openings of the through-hole 14 is closed by the copper foil 30a which is the power supply layer. On the other hand, as the other of the openings of the through-hole 14 is free, and the anode plate 40 of the filling metal is disposed at the position slightly apart from the substrate 10, the conductive metal 34 is deposited on the copper foil 30a in the interior of the through-hole 14 as the electrolytic plating progresses whereby the conductive metal is growing in the interior of the through-hole 14 to perfectly fill the interior of the through-hole 14 with the conductive metal.

According to such electrolytic plating using the copper foil 30a as a plating power supply layer, it is easy to fill the interior of the through-hole 14 with the conductive metal 34 even if the through-hole has a small diameter. In this regard, when the electrolytic plating is carried out by using the copper foil 30a as a plating power supply layer, an exposed surface of the copper foil 30a may be covered with a plate-protection film as a whole so that a thickness of the copper foil 30a does not increase by the plating during the formation of the conductive metal 34. An electrolytic plating for filling the recess 14a is a solder plating so that the recess 14a is filled with solder.

According to JP-A 10-275966, a bonding pin is inserted into a through-hole connected to a conductor circuit of a printed circuit board which is bonded to a pad of a mated substrate via the bonding pin. The bonding pin is made of material not melted at a temperature at which the bonding pin is heat-bonded to the mated pad, and consists of a bonding head forming a section to be bonded with the mated pad, having a diameter larger than that of the opening of the through-hole, a leg having a size capable of inserting into the interior of the through-hole. The leg is bonded to the through-hole by conductive material such as solder inserted into the through-hole.

As shown in JP-A 2003-332705 described above, electrolytic plating, as a method for filling the through-hole of the circuit board with conductive material, is problematic particularly when an inner diameter of the through-hole is small in that a long time is necessary for the growth of the conductive material in the through-hole, the growth speed of the conductive material is slow in a central area of the through-hole although that in the wall surface area and the peripheral area in the vicinity thereof is relatively fast whereby the uniform growth of the conductive material is not expected, and air bubbles may occur in the conductive material, during the depositing of the metal in the electrolytic plating, and form voids therein to disturb the formation of the dense growth of the conductive material. To solve such problems, the agitation of plating solution in the electrolytic tank may be carried out, for example. However, a satisfactory result has not been obtained.

An object of the present invention is to provide a method for manufacturing a semiconductor substrate capable of uniformly and quickly filling the interior of a through-hole with conductive material when the through-hole of the substrate is filled with conductive material.

To achieve the above-mentioned object, according to the present invention, a method for producing a semiconductor substrate, comprising the following steps of: forming through-holes in a substrate, disposing molten solder on one surface of the substrate, and pressing the solder onto the substrate by a press while heating to melt the solder to be filled into the through-holes in the substrate. Thereby, it is possible to fill the solder which is conductive material in the through-hole of the semiconductor substrate at a low cost, whereby it is possible to complete the filling operation of the conductive material into the through-hole of the substrate in a shorter time.

To facilitate the wetting of a wall of the through-hole in the substrate by the solder, a wetting power improvement agent is preliminarily coated on the through-hole of the substrate. In this case, as the wetting power improvement agent, a flux having a relatively low viscosity is used. By such a treatment for improving the wetting power between the wall surface of the through-hole in the substrate and the solder, it is possible to densely fill the conductive material into the through-hole of the semiconductor substrate in a short time.

When the solder is pressed onto the semiconductor substrate by the press, the solder is sucked from the opposite side of the substrate. By applying such a suction from the opposite side, it is possible to assist the pressure caused by the press to shorten a time necessary for filling the conductive material in the through-hole from one surface to the other surface of the substrate.

The pressing operation of the solder onto the substrate by the press by the press is carried out under a reduced pressure environment. By carrying out the pressing operation under such a reduced pressure environment, a surface tension of the solder decrease when the solder is filled in the through-hole of the semiconductor substrate, whereby it is possible to densely fill the conductive material into the through-hole of the substrate in a shorter time.

### BRIEF DESCRIPTION OF THE DRAWINGS

The present invention will be described in more detail below with reference to the attached drawings wherein:
Figs. 1(a), 1(b), 1(c), 1(d), 1(e) and 1(f) sequentially illustrate a prior art processes for producing a circuit board ;
Fig. 2 illustrates a process for filling the through-hole by the prior art electrolytic plating; and
Fig. 3 illustrates a method for producing a semiconductor substrate including a process for filling the through-hole by a press according to the present invention.

### DESCRIPTION OF THE PREFERRED EMBODIMENTS

In Fig. 3, the semiconductor substrate 10 is preferably made of insulation material such as a ceramic, for example, silicon substrate. A resinous insulating substrate, such as a glass-epoxy substrate, may be used. In such a case, a substrate high in heat resistance is used. This is because the melting point of a tin/silver solder is 260°C.

The silicon substrate 10 has a thickness, for example, in a range from 200 to 250 µm and is provided with a number of through-holes 14 having a diameter of 60 µm and arranged at a pitch in a range from 100 to 200µm. Although a process for forming the through-holes 14 is not shown, it is carried out by the laser beam machining or precision drilling in the same manner as in the prior art.

Prior to the subsequent pressing process, the through-hole 14 of the silicon substrate 10 is subjected to the coating operation of a flux for forming a film for improving the wetting power between the wall of the through-hole 14 and solder. The flux used preferably has as low a viscosity as possible. Preferably, to facilitate the wetting of the silicon material forming the substrate 10, a thin copper film 14a is preliminarily formed on the wall surface of the through-hole 14 by sputtering or plating.

Then, a plate-like solder 42 is mounted to one surface of the silicon substrate 10. The solder 42 is preferably tin/silver solder having a relatively high melting point of approximately 260°C. Alternatively, lead-rich tin/lead solder may be used. A size of the plate-like solder 42 is such that it has an area covering a region of the silicon substrate 10 provided with a number of through-holes 14 (for example, a 10 mm square area) and a volume larger than a total volume of all the through-hoes 14 to be filled therewith.

To easily melt the solder 42 in a shorter time in the subsequent pressing process, the silicon substrate 10 itself is preferably preliminarily heated to approximately 150°C when the plate-like solder 42 is mounted to the silicon substrate 10. Thereby, prior to the subsequent pressing process, the solder 42 is heated to a temperature close to 150°C which is the temperature of the silicon substrate 10.

The plate-like solder 42 is pressed by the press 40 from the one surface of the silicon substrate 10 on which is disposed the plate-like solder 42, and heated. The press 40 is preliminarily heated to a temperature higher than the melting point of the solder 42 (if the solder 42 is tin/silver solder, the melting point thereof is 260°C). Accordingly, after the plate-like solder 42 is pressed by the press 40, heat of the press 40 is transferred to the plate-like solder 42 to melt the latter. At the commencement of the melting of the solder 42, the press 40 is forcibly moved toward the one surface of the silicon substrate 10 to press the melted and fluidized solder 42a into the through-holes 14 of the silicon substrate 10.

To heat the pate-like solder 40 in a shorter time, in addition to heating the press 40 itself, other heating means such as an electric heater may be provided around the plate-like solder 40.

As the film 14a for improving the wetting by the solder is preliminarily coated on the wall surface of the through-hole 14 in the silicon substrate 10, when the fluidized solder 42a flows into the through-hole 14, the adverse effect of the surface tension of the solder is less, whereby the solder is favorably in close contact with the wall surface of the through-hole.

A suitable suction device not shown is provided for sucking the fluidized solder 42a from the other surface side of the silicon substrate 10 to facilitate the flow-in of the solder 42a into the through-hole 14 when the plate-like solder 42 is pressed by the press 40 from the one surface side of the silicon substrate 10, whereby the movement of the fluidized solder 42a in the through-hole 14 is accelerated. Alternatively, the devices including the press 40 may be operated under a reduced pressure.

When the through-hole 42a of the silicon substrate 10 is filled with the solder 42a, the press 40 is moved away from the silicon substrate 10, and the residual solder adhered onto the surface of the silicon substrate 10 is removed. Thus, the operation is finished.

The present invention has been described above based on the preferred embodiment thereof with reference to the attached drawings. The present invention, however, is not limited to the above-mentioned embodiment but includes various changes and modifications thereof without departing from the scope of the present invention.

As described above, according to the present invention, through-holes are formed in a semiconductor substrate, and a solder is disposed on one surface thereof and heated and melted to fill the through-hole in the substrate therewith, whereby it is possible to uniformly and quickly fill the through-holes with the conductive material, resulting in a dense conductor via.

## Claims

1. A method for producing a semiconductor substrate (10), comprising the following steps of: forming through-holes (14) in a substrate (10), disposing solder (42) on one surface of the substrate (10), and pressing the solder (42) onto the substrate (10) by a press while heating to melt the solder (42) to be filled into the through-holes (14) in the substrate (10), **characterized in that** the substrate (10) is made of silicon material.

2. The method as set forth in claim 1, wherein the press (40) is moved toward the one surface of the substrate (10) at the commencement of the melding of the solder (42).

3. The method as set forth in claim 1 or 2, wherein the press (40) is preliminarily heated to a temperature higher than the melting point of the solder (42), in particular higher than 260°C.

4. The method as set forth in one of claims 1 to 3, wherein the substrate (10) itself is preliminarily heated to approximately 150°C when the solder (42) is mounted to the substrate (10).

5. The method as set forth in one of claims 1 to 4, wherein a thin copper film (14a) is preliminarily formed on a wall surface of the through-hole (14) by sputtering or plating, facilitating a wetting of the silicon material.

6. The method as set forth in claim 1 to 5, wherein a wetting power improvement agent is preliminarily coated on the through-hole (14) of the substrate (10) to facilitate the wetting power between a wall of the through-hole (14) in the substrate (10) and the solder(42).

7. The method as set forth in claim 6, wherein as the wetting power improvement agent, a flux having a relatively low viscosity is used.

8. The method as set forth in one of claim1 to 7, wherein in addition to heating the press (40) itself, other heating means are provided around the solder, in particular an electric heater.

9. The method as set forth in one of claims 1 to 8, wherein the solder(42) is sucked from the opposite side of the substrate (10), when the solder(42) is pressed onto the substrate (10) by the press (40).

10. The method as set forth in one of claims 1 to 9, wherein the pressing operation of the solder (42) onto the substrate (10) by the press (40) is carried out under a reduced pressure environment.

11. The method as set forth in one of claims 1 to 10, wherein the solder (42) is plate-like.

12. The method as set forth in one of claims 1 to 11, wherein the solder (42) is tin/silver solder or tin/lead solder.

## Patentansprüche

1. Verfahren zur Herstellung eines Halbleitersubstrats (10), das die folgenden Schritte aufweist: Ausbilden von Durchgangslöchern (14) im Substrat (10), Aufbringen von Weichlot (42) auf einer Oberfläche des Substrats (10) und Pressen des Weichlots (42) mittels einer Presse auf das Substrat (10), wobei eine Erwärmung stattfindet, um das Weichlot (42) zu schmelzen, mit dem die Durchgangslöcher (14) im Substrat (10) zu füllen sind, **dadurch gekennzeichnet, dass** das Substrat (10) aus einem Siliziummaterial besteht.

2. Verfahren nach Anspruch 1, bei dem die Presse (40) zu Beginn des Schmelzens des Weichlots (42) in Richtung der einen Oberfläche des Substrats (10) bewegt wird.

3. Verfahren nach Anspruch 1 oder 2, bei dem die Presse (40) zunächst auf eine Temperatur über dem Schmelzpunkt des Weichlots (42) erwärmt wird, insbesondere auf über 260°C.

4. Verfahren nach einem der Ansprüche 1 bis 3, bei dem das Substrat (10) selbst zunächst auf ca. 150°C erwärmt wird, wenn das Weichlot (42) auf dem Substrat (10) aufgebracht wird.

5. Verfahren nach einem der Ansprüche 1 bis 4, bei dem ein Kupferfilm (14a) auf einer Wandoberfläche des Durchgangslochs (14) durch Sputtern oder Plattieren vorläufig ausgebildet wird, wodurch die Benetzung des Siliziummaterials erleichtert wird.

6. Verfahren nach einem der Ansprüche 1 bis 5, bei dem das Durchgangsloch (14) im Substrat (10) zunächst mit einem das Benetzungsvermögen verbessernden Mittel beschichtet wird, um das Benetzungsvermögen zwischen einer Wand des Durchgangslochs (14) im Substrat (10) und dem Weichlot (42) zu verstärken.

7. Verfahren nach Anspruch 6, bei dem als Mittel zur Verbesserung des Benetzungsvermögens ein Flussmittel mit relativ niedriger Viskosität verwendet wird.

8. Verfahren nach einem der Ansprüche 1 bis 7, bei dem zusätzlich zur Erwärmung der Presse (40) selbst andere Heizmittel um das Weichlot vorgesehen sind, insbesondere ein elektrisches Heizgerät.

9. Verfahren nach einem der Ansprüche 1 bis 8, bei dem das Weichlot (42) von der gegenüberliegenden Seite des Substrats (10) aus angesaugt wird, wenn das Weichlot (42) durch die Presse (40) auf das Substrat (10) gepresst wird.

10. Verfahren nach einem der Ansprüche 1 bis 9, bei dem der Pressvorgang des Weichlots (42) auf das Substrat (10) mittels der Presse (40) in einer Umgebung mit verringertem Druck stattfindet.

11. Verfahren nach einem der Ansprüche 1 bis 10, bei dem das Weichlot (42) plattenartig ist.

12. Verfahren nach einem der Ansprüche 1 bis 11, bei dem das Weichlot (42) ein Zinn-/Silber- oder ein Zinn-/Blei-Weichlot ist.

## Revendications

1. Un procédé de production d'un substrat semi-conducteur (10) comprenant les étapes suivantes : la réalisation de trous de passage (14) dans un substrat (10), la disposition d'une brasure tendre (42) sur une surface du substrat (10), et le pressage de la brasure tendre (42) sur le substrat (10) à l'aide d'une presse, en chauffant la brasure tendre, afin de remplir les trous de passage (14) dans le substrat (10) jusqu'au point de fusion, **caractérisé en ce que** le substrat (10) est fait d'un matériau en silice.

2. Le procédé selon la revendication 1, où la presse (40) est déplacée au début de la fusion de la brasure tendre (42) vers une surface du substrat (10).

3. Le procédé selon les revendications 1 ou 2, où la presse est préchauffée à une température supérieure au point de fusion de la brasure tendre (42), en particulier supérieure à une température de 260°C.

4. Le procédé selon les revendications 1 à 3, où le substrat (10) lui-même est préchauffé à une température supérieure à 150°C lorsque la brasure tendre est disposée sur le substrat (10).

5. Le procédé selon les revendications 1 à 4, où une mince couche de cuivre (14a) est précédemment formée sur une surface de la paroi du trou de passage (14) par pulvérisation ou revêtement métallique, facilitant un mouillage du matériau en silice.

6. Le procédé selon les revendications 1 à 5, où un agent renforçant le pouvoir mouillant est appliqué sur le trou de passage (14) du substrat (10) pour améliorer le pouvoir mouillant entre une paroi du trou de passage (14) dans le substrat (10) et la brasure tendre (42).

7. Le procédé selon la revendication 6, où, grâce à un agent renforçant le pouvoir mouillant, on utilise un flux à la viscosité relativement élevée.

8. Le procédé selon les revendications 1 à 7, où d'autres moyens de chauffage sont mis à disposition autour de la brasure tendre, en particulier un chauffage électrique en plus du réchauffement de la presse (40) elle-même,

9. Le procédé selon les revendications 1 à 8, où la brasure tendre (42) est aspirée à partir du côté opposé du substrat (10) lorsque la brasure tendre (42) est pressée par une presse (40) sur le substrat (10).

10. Le procédé selon les revendications 1 à 9, où l'opération de pressage de la brasure tendre (42) sur le substrat (10) par la presse (40) est effectuée dans un environnement à pression réduite.

11. Le procédé selon les revendications 1 à 10, où la brasure tendre (42) est lamellaire.

12. Le procédé selon les revendications 1 à 10, où la brasure tendre (42) est une brasure tendre en étain / argent ou en étain / plomb.
